# EUROPÄISCHE PATENTSCHRIFT

(11) **EP 3 649 476 B1**
(45) Veröffentlichungstag und Bekanntmachung des Hinweises auf die Patenterteilung: **12.03.2025**
(21) Anmeldenummer: 18738255.1
(22) Anmeldetag: 02.07.2018
(51) Int. Cl.: G01R 1/20, G01R 35/00, G01R 31/36

(54) **VORRICHTUNG UND VERFAHREN ZUM ÜBERPRÜFEN EINER FUNKTIONSFÄHIGKEIT EINES SYSTEMWIDERSTANDS EINES BATTERIESYSTEMS**
DEVICE AND METHOD FOR CHECKING THE FUNCTIONALITY OF A SYSTEM RESISTOR OF A BATTERY SYSTEM
DISPOSITIF ET PROCÉDÉ PERMETTANT DE VÉRIFIER UNE APTITUDE À FONCTIONNER D'UNE RÉSISTANCE D'UN SYSTÈME DE BATTERIE

(30) Priorität: 05.07.2017 DE 102017211476
(43) Veröffentlichungstag der Anmeldung: 13.05.2020
(73) Patentinhaber: Robert Bosch GmbH, 70442 Stuttgart (DE)
(72) Erfinder: SALZIGER, Jan, 71679 Asperg (DE); GLEITER, Andreas, 70437 Stuttgart (DE); LANDA, Sven, 74336 Brackenheim (DE); SCHNEIDER, Frank, 01454 Radeberg (DE)
(86) Internationale Anmeldenummer: PCT/EP2018/067761
(87) Internationale Veröffentlichungsnummer: WO 2019/007878

(56) Entgegenhaltungen:
- WO-A1-03/081263
- DE-A1- 102014 208 680
- US-A1- 2013 154 672

## Beschreibung

Die Erfindung betrifft eine Vorrichtung und ein Verfahren zum Überprüfen einer Funktionsfähigkeit eines Systemwiderstands bzw. eines ersten Widerstands eines Batteriesystems.

Die Vorrichtung zum Überprüfen einer Funktionsfähigkeit eines ersten Widerstands eines Batteriesystems weist eine Konstantstromquelle, einen Schalter, einen zweiten Widerstand, ein erstes Mittel und ein zweites Mittel auf.

Das erste Mittel ist dazu eingerichtet, einen ersten Spannungswert als Spannungsabfall über dem ersten Widerstand zu erfassen, einen ersten Stromwert in Abhängigkeit des ersten Spannungswerts und eines Nennwerts des ersten Widerstands zu bestimmen und den ersten Stromwert mit Hilfe einer Verbindung an das zweite Mittel zu übertragen.

Das erste Mittel weist einen Verstärker mit einem dynamischen ersten Verstärkungsfaktor auf.

Das zweite Mittel ist dazu eingerichtet, einen zweiten Spannungswert zu erfassen und einen zweiten Stromwert in Abhängigkeit des zweiten Spannungswerts und eines Nennwerts eines zweiten Widerstands zu bestimmen.

Um eine Stromüberwachung mit ASIL-C im Betrieb eines Batteriesystems sicherzustellen, werden zwei Systemwiderstände, die Teile des Batteriesystems sind, verwendet.

Nachteilig ist hierbei, dass eine Stromüberwachung erst nach dem Hochlauf bzw. Zuschalten des Batteriesystems durchgeführt werden kann.

### Stand der Technik

Das Dokument D1 (US 2013/0154672 A1) offenbart ein Verfahren und ein System zur Kalibrierung einer Strommessung. Hierzu weist das System einen ersten und zweiten Widerstand auf, eine Stromquelle sowie ein Steuergerät. Zum Überprüfen einer Funktionsfähigkeit eines ersten Widerstands wird ein Diagnosemodus gestartet und durch einen Vergleich eines ersten ermittelten Stromwert mit einem zweiten ermittelten Stromwert die Funktionsfähigkeit des ersten Widerstands überprüft.

Das Dokument D2 (WO 03/081263 A1) offenbart eine Schaltungsanordnung und ein Verfahren zum Überprüfen eines Stromkreises. Hierzu weist die Schaltungsanordnung ein Steuergerät und einen ersten Stromsensor zum Erfassen eines Stromflusses zum Verbraucher auf, wobei ein zweiter Stromsensor, zum Erfassen eines Stromflusses zum Verbraucher vorgesehen ist und durch einen Vergleich mit dem vom ersten Stromsensor erfassten Strom den Stromkreis überprüft.

Das Dokument D3 (DE 10 2014 208 680 A1) offenbart ein Verfahren zur Überwachung von Stromsensoren. Hierzu weist die elektrische Schaltung einen Stromsensor zum Ermitteln des Gesamtstromes in der Gesamtleitung auf, wobei jeweils für die Leitungspfade ein zugehöriger Skalierungsfaktor bestimmt wird und durch die Stromsensoren in den jeweiligen Leitungspfaden gemessene Teilströme ermittelt werden, ein Gesamtstrom in der Gesamtleitung durch den Stromsensor ermittelt wird und zur Überwachung der Stromsensoren die berechneten Gesamtströme untereinander sowie jeweils mit dem gemessenen Gesamtstrom verglichen werden.

Die Aufgabe der Erfindung ist eine Stromüberwachung gemäß ASIL-C vor dem Zuschalten eines Batteriesystems durchzuführen.

### Offenbarung der Erfindung

Die Erfindung ist durch die Vorrichtung des Anspruchs 1 und das Verfahren des Anspruchs 3 definiert. Erfindungsgemäß ist das zweite Mittel dazu eingerichtet, den ersten Stromwert und den zweiten Stromwert zu vergleichen, wobei das zweite Mittel dazu eingerichtet ist, ein erstes Signal zu erzeugen, wenn der erste Stromwert und der zweite Stromwert im Wesentlichen einen gleichen Wert aufweisen, wobei das erste Signal die Funktionsfähigkeit des ersten Widerstands repräsentiert. Das erste Mittel ist dazu eingerichtet, einen zweiten Verstärkungsfaktor in Abhängigkeit des ersten Stromwerts und des dritten Stromwerts zu bestimmen und mit dem dynamischen ersten Verstärkungsfaktor zu vergleichen. Das erste Mittel ist dazu eingerichtet, ein zweites Signal zu erzeugen, wenn der dynamische erste Verstärkungsfaktor und der zweite Verstärkungsfaktor im Wesentlichen übereinstimmen.

Der Vorteil ist hierbei, dass der erste Widerstand mit einer Genauigkeit von ASIL-C geprüft werden kann.

Ferner ist ein dritter Widerstand vorgesehen, wobei das erste Mittel dazu eingerichtet ist, einen dritten Spannungswert zu erfassen, einen dritten Stromwert in Abhängigkeit des dritten Spannungswerts und eines Nennwerts des dritten Widerstands zu bestimmen und den dritten Stromwert mit Hilfe der Verbindung an das zweite Mittel zu übertragen und das zweite Mittel das erste Signal erzeugt, wenn der erste Stromwert, der zweite Stromwert und der dritte Stromwert im Wesentlichen den gleichen Wert aufweisen.

Vorteilhaft ist hierbei, dass eine Stromüberwachung vor dem Hochlauf des Batteriesystems den Standard ASIL-C erfüllt. Weiter vorteilhaft ist, dass das erste Mittel Spannungswerte stark unterschiedlicher Größenordnungen erfassen kann. Weiter vorteilhaft ist hierbei, dass die Funktionsfähigkeit des dynamischen Verstärkers des ersten Mittels auf einfache Weise überprüft werden kann.

In einer weiteren Ausgestaltung ist das erste Mittel ein Analog-Front-End und das zweite Mittel eine Steuereinheit eines Batteriemanagementsystems des Batteriesystems.

Das erfindungsgemäße Verfahren zum Überprüfen einer Funktionsfähigkeit eines ersten Widerstands eines Batteriesystems umfasst das Starten eines Diagnosemodus eines zweiten Mittels, das Schließen eines Schalters, das Einschalten einer Konstantstromquelle, das Erfassen eines ersten Spannungswerts mit Hilfe eines ersten Mittels, das Bestimmen eines ersten Stromwerts in Abhängigkeit des ersten Spannungswerts und eines Nennwerts des ersten Widerstands, sowie das Übertragen des ersten Stromwerts an das zweites Mittel.

Das Verfahren umfasst des Weiteren das Erfassen eines zweiten Spannungswerts mit Hilfe des zweiten Mittels und das Bestimmen eines zweiten Stromwerts in Abhängigkeit des zweiten Spannungswerts und eines Nennwerts eines zweiten Widerstands. Außerdem umfasst das Verfahren das Erzeugen eines ersten Signals, das die Funktionsfähigkeit des ersten Widerstands repräsentiert, wenn der erste Stromwert und der zweite Stromwert im Wesentlichen einen gleichen Wert aufweisen bzw. im Wesentlichen gleich sind.

Ferner umfasst das Verfahren das Erfassen eines dritten Spannungswerts mit Hilfe des ersten Mittels, Bestimmen eines dritten Stromwerts in Abhängigkeit des dritten Spannungswerts und eines Nennwerts des dritten Widerstands, Übertragen des dritten Stromwerts an das zweite Mittel und Erzeugen des ersten Signals , wenn der erste Stromwert, der zweite Stromwert und der dritte Stromwert im Wesentlichen den gleichen Wert aufweisen.

Ferner weist das erste Mittel einen dynamischen ersten Verstärkungsfaktor auf, wobei ein zweiter Verstärkungsfaktor in Abhängigkeit des ersten Stromwerts und des dritten Stromwerts bestimmt wird und der dynamische erste Verstärkungsfaktor mit dem zweiten Verstärkungsfaktor verglichen wird. Es wird ein zweites Signal erzeugt, wenn der dynamische erste Verstärkungsfaktor und der zweite Verstärkungsfaktor im Wesentlichen übereinstimmen.

Das Verfahren umfasst zusätzlich das Beenden des Diagnosemodus, indem der Schalter geöffnet wird.

Weitere Vorteile ergeben sich aus der nachfolgenden Beschreibung von Ausführungsbeispielen bzw. aus den abhängigen Patentansprüchen.

### Kurze Beschreibung der Zeichnungen

Die vorliegende Erfindung wird nachfolgend anhand bevorzugter Ausführungsformen und beigefügter Zeichnungen erläutert. Es zeigen:
- Figur 1: ein Ersatzschaltbild eines Batteriesystems mit einer Vorrichtung zum Überprüfen einer Funktionsfähigkeit eines ersten Widerstands des Batteriesystems gemäß dem Stand der Technik;
- Figur 2: ein Ersatzschaltbild eines Batteriesystems mit einer erfindungsgemäßen Vorrichtung zum Überprüfen der Funktionsfähigkeit eines ersten Widerstands des Batteriesystems;
- Figur 3: ein Verfahren zum Überprüfen der Funktionsfähigkeit eines ersten Widerstands des Batteriesystems gemäß dem Stand der Technik; und
- Figur 4: ein erfindungsgemäßes Verfahren zum Überprüfen der Funktionsfähigkeit eines ersten Widerstands des Batteriesystems.

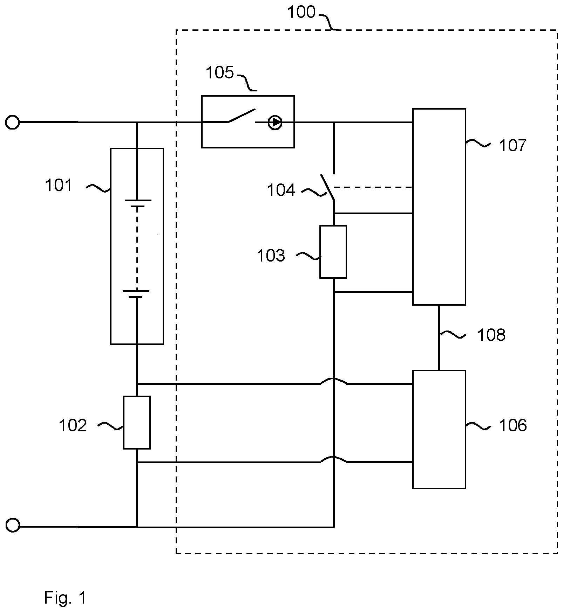

Figur 1 zeigt ein Ersatzschaltbild eines Batteriesystems mit einer Vorrichtung 100 zum Überprüfen einer Funktionsfähigkeit eines ersten Widerstands 102 des Batteriesystems gemäß dem Stand der Technik. Die Vorrichtung 100 weist eine schaltbare bzw. einschaltbare Konstantstromquelle 105, einen Schalter 104, einen zweiten Widerstand 103, ein erstes Mittel 106 und ein zweites Mittel 107 auf. Das erste Mittel 106 weist eine erste Spannungsversorgung und das zweite Mittel 107 eine zweite Spannungsversorgung auf. Mit anderen Worten das erste Mittel 106 und das zweite Mittel 107 weisen unabhängige Spannungsversorgungen bzw. Referenzspannungen auf. Das bedeutet, dass Spannungsfehler der ersten Spannungsversorgung nicht auf das zweite Mittel übertragen werden. Das erste Mittel 106 und das zweite Mittel 107 sind mit einer Verbindung 108 bzw. über eine Verbindung 108 verbunden. Bei der Verbindung 108 handelt es sich um eine Datenleitung. Mit anderen Worten das erste Mittel und das zweite Mittel weisen lediglich eine spannungsunabhängige Verbindung auf, nämlich eine Datenleitung. Das erste Mittel 106 ist dazu eingerichtet, die Konstantstromquelle 105 einzuschalten bzw. einzustellen. Des Weiteren ist das erste Mittel 106 dazu eingerichtet, einen ersten Spannungswert zu erfassen. Beim ersten Spannungswert handelt es sich hierbei um einen Spannungsabfall über bzw. am ersten Widerstand 102. Der erste Widerstand 102 wird auch als Systemwiderstand des Batteriesystems bezeichnet und ist somit Teil des Batteriesystems. Das zweite Mittel 107 ist dazu eingerichtet, einen zweiten Spannungswert zu erfassen. Beim zweiten Spannungswert handelt es sich um einen Spannungsabfall über bzw. an einem zweiten Widerstand 103. Figur 1 zeigt außerdem eine Batterie 101, insbesondere eine Lithium-Ionen-Batterie. Das erste Mittel 106 ist beispielsweise eine Steuereinheit eines Batteriemanagementsystems des Batteriesystems, insbesondere ein Zentralrechner. Das zweite Mittel 107 ist beispielsweise ein analoges Frontend des Batteriesystems. Der Widerstandswert des zweiten Widerstands 103 ist wesentlich größer als der Widerstandswert des ersten Widerstands 102, beispielsweise um den Faktor Hundert. Die Vorrichtung 100 ist beispielsweise auf einer Leiterplatte oder Platine angeordnet, wohingegen der erste Widerstand als Teil des Batteriesystems auf einem von der Leiterplatte bzw. Platine unabhängigen Träger angeordnet ist.

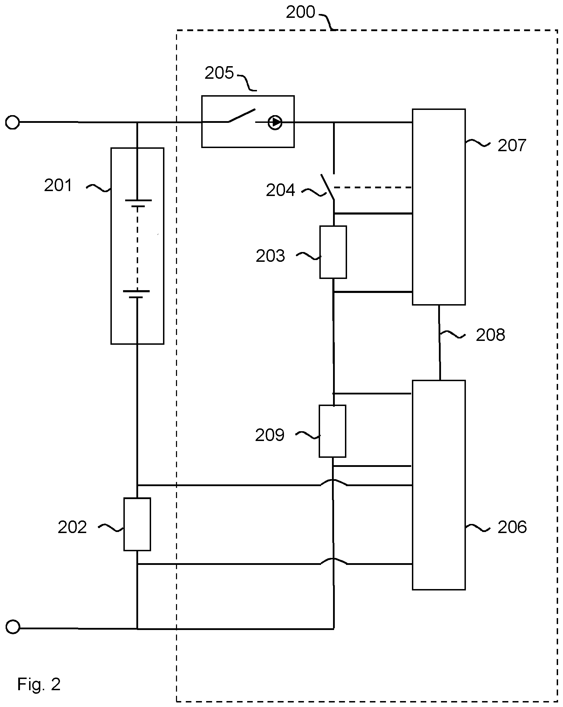

Figur 2 zeigt ein Ersatzschaltbild eines Batteriesystems mit einer erfindungsgemäßen Vorrichtung 200 zum Überprüfen der Funktionsfähigkeit des ersten Widerstands 202 des Batteriesystems. Die Vorrichtung 200 umfasst die Konstantstromquelle 205, den Schalter 204, den zweiten Widerstand 203, einen dritten Widerstand 209, das erste Mittel 206 und das zweite Mittel 207. Das erste Mittel 206 weist eine erste Spannungsversorgung und das zweite Mittel 207 eine zweite Spannungsversorgung auf. Das erste Mittel 206 und das zweite Mittel 207 sind mit einer Verbindung 208 verbunden, wobei die Verbindung 208 insbesondere eine Datenleitung ist.

Die Widerstandswerte des ersten Widerstands 202, des zweiten Widerstands 203 und des dritten Widerstands 209 sind unterschiedlich. Die Widerstandswerte des ersten Widerstands 202 und des dritten Widerstands 209 liegen um einen Faktor von mehreren Hundert auseinander. Die Nominalwerte bzw. Nennwerte des ersten Widerstands 202 und des dritten Widerstands 209 sind beispielsweise in einem Speicher des ersten Mittels 206 hinterlegt, d. h. sie sind dem ersten Mittel 206 bekannt. Der Nominalwert bzw. Nennwert des zweiten Widerstands 204 ist beispielsweise in einem Speicher des zweiten Mittels 207 hinterlegt, d. h. er ist dem zweiten Mittel 207 bekannt. Das erste Mittel 206 umfasst beispielsweise einen Multiplexer und eine Verstärkerschaltung mit einem dynamischen Verstärkungsbereich. Das zweite Mittel 207 ist beispielsweise ein Mikrocontroller. Der erste Widerstand 202 des Batteriesystems weist dabei den geringsten Widerstandswert auf, damit die Verlustleistung im Betrieb des Batteriesystems über den ersten Widerstand 202 gering ist. Der erste Widerstand 202 weist beispielsweise einen Widerstandswert von 100 µΩ, der zweite Widerstand 203 einen Widerstandswert von 50 mΩ und der dritte Widerstand 209 einen Widerstandswert von 2,2 Ω auf.

In einem Ausführungsbeispiel ist das erste Mittel 206 dazu eingerichtet, die Verstärkung der Verstärkerschaltung zu überprüfen, da im späteren Betrieb des Batteriesystems sichergestellt sein muss, dass der Verstärker des ersten Mittels 206 einwandfrei funktioniert, um eine Stromüberwachung nach ASIL-C mit nur einem Systemwiderstand gewährleisten zu können.

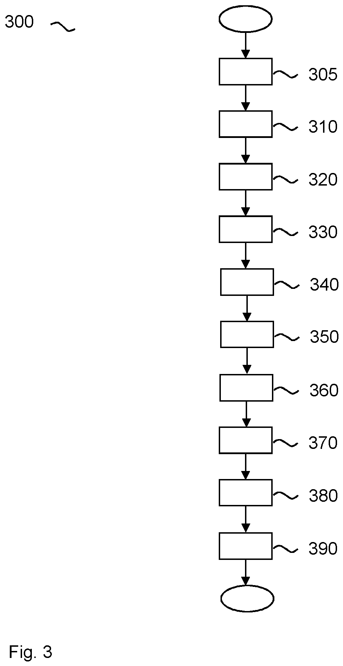

Figur 3 zeigt ein Verfahren 300 zum Überprüfen einer Funktionsfähigkeit eines ersten Widerstands eines Batteriesystems während eines Anlaufens bzw. Hochlaufs des Batteriesystems gemäß dem Stand der Technik. Das Verfahren wird mit einem Schritt 305 gestartet, in dem ein erstes Mittel in einen Diagnosemodus geschaltet wird. In einem folgenden Schritt 310 wird ein Schalter geschlossen, sodass ein geschlossener Stromkreis erzeugt wird, der die Konstantstromquelle, den Schalter, den ersten Widerstand, den zweiten Widerstand und eine Batterie umfasst. In einem folgenden Schritt 320 wird die Konstantstromquelle mit Hilfe eines ersten Mittels eingeschaltet. Mit anderen Worten es wird ein vorgegebener Strom in den geschlossenen Stromkreis eingeprägt bzw. es wird ein vorgegebener Strom im geschlossenen Stromkreis eingestellt. In einem folgenden Schritt 330 wird ein erster Spannungswert mit Hilfe des ersten Mittels erfasst. In einem folgenden Schritt 340 wird ein erster Stromwert in Abhängigkeit des ersten Spannungswerts und eines Nennwerts des ersten Widerstands bestimmt. In einem folgenden Schritt 350 wird der erste Stromwert an das zweite Mittel übertragen. In einem folgenden Schritt 360 wird ein zweiter Spannungswert erfasst. In einem folgenden Schritt 370 wird ein zweiter Stromwert in Abhängigkeit des zweiten Spannungswerts und eines Nennwerts des zweiten Widerstands bestimmt. Die Schritte 330 bis 370 können auch in einer anderen Reihenfolge durchgeführt werden. In einem folgenden Schritt 380 wird ein erstes Signal erzeugt, das die Funktionsfähigkeit des ersten Widerstands repräsentiert, wenn der erste Stromwert und der zweite Stromwert im Wesentlichen einen gleichen Wert aufweisen. Durch die Verwendung der Nennwerte der Widerstände können Veränderungen, z. B. Fehlfunktion oder Altersdrift innerhalb des ersten Widerstands durch eine Stromveränderung erkannt werden. Dabei ist der zweite Stromwert sozusagen der Richtwert mit dem der erste Stromwert verglichen wird. Dabei kann der erste Stromwert innerhalb eines Toleranzbereichs um den zweiten Stromwert abweichen. Mit anderen Worten der Begriff "im Wesentlichen gleich" bedeutet, dass sich der erste Stromwert im Toleranzbereich bzw. Toleranzband des ersten Stromwerts befindet. Optional können der erste Stromwert und der zweite Stromwert in einem Speicher des zweiten Mittels gespeichert werden. In einem folgenden Schritt 390 wird der Diagnosemodus erfolgreich beendet und das erste Mittel schaltet das Batteriesystem in einen Betriebsmodus. Dabei wird ein Vorladesignal erzeugt, das einen Vorladevorgang eines Zwischenkreises des Batteriesystems startet.

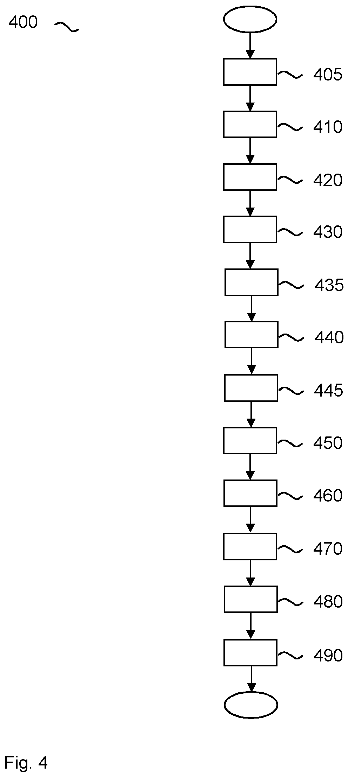

Figur 4 zeigt ein erfindungsgemäßes Verfahren 400 zum Überprüfen einer Funktionsfähigkeit eines ersten Widerstands eines Batteriesystems während eines Anlaufens bzw. Hochlaufs des Batteriesystems. Das Verfahren wird mit einem Schritt 405 gestartet, in dem ein erstes Mittel in einen Diagnosemodus geschaltet wird. In einem folgenden Schritt 410 wird ein Schalter geschlossen, sodass ein geschlossener Stromkreis entsteht. In einem folgenden Schritt 420 wird die Konstantstromquelle mit Hilfe eines ersten Mittels eingeschaltet. In einem folgenden Schritt 430 wird ein erster Spannungswert mit Hilfe des ersten Mittels erfasst. In einem folgenden Schritt 435 wird ein dritter Spannungswert mit Hilfe des ersten Mittels erfasst. In einem folgenden Schritt 440 wird ein erster Stromwert in Abhängigkeit des ersten Spannungswerts und des ersten Widerstands bestimmt. In einem folgenden Schritt 445 wird ein dritter Stromwert in Abhängigkeit des dritten Spannungswerts und eines dritten Widerstands bestimmt. Mit anderen Worten der erste Spannungswert und der dritte Spannungswert werden zeitlich nacheinander erfasst, beispielsweise mit Hilfe eines Multiplexers. Nochmals anders ausgedrückt wird zur Erfassung der ersten Spannungswerte und der dritten Spannungswerte ein sequentielles Sampling durchgeführt, wobei für den ersten Spannungswert eine größere Verstärkung bzw. ein größerer Verstärkungsfaktor verwendet wird als für den dritten Spannungswert. In einem folgenden Schritt 450 werden der erste Stromwert und der dritte Stromwert an das zweite Mittel übertragen. In einem folgenden Schritt 460 wird ein zweiter Spannungswert erfasst. In einem folgenden Schritt 470 wird ein zweiter Stromwert in Abhängigkeit des zweiten Spannungswerts und eines zweiten Widerstands bestimmt. Die Schritte 430 bis 470 können auch in einer anderen Reihenfolge durchgeführt werden. In einem folgenden Schritt 480 wird das erste Signal erzeugt, das die Funktionsfähigkeit des ersten Widerstands repräsentiert, wenn der erste Stromwert, der zweite Stromwert und der dritte Stromwert im Wesentlichen den gleichen Wert aufweisen. Dabei ist auch hier der zweite Stromwert sozusagen der Richtwert mit dem der erste Stromwert und der dritte Stromwert verglichen werden. Dabei können der erste Stromwert und der dritte Stromwert innerhalb eines Toleranzbereichs um den zweiten Stromwert abweichen. Mit anderen Worten der Begriff "im Wesentlichen gleich" bedeutet, dass sich der erste Stromwert und der dritte Stromwert im Toleranzbereich bzw. Toleranzband des ersten Stromwerts befinden. In einem folgenden Schritt 490 wird der Diagnosemodus erfolgreich beendet und das erste Mittel schaltet das Batteriesystem in einen Betriebsmodus, wobei ein Vorladesignal erzeugt, das einen Vorladevorgang eines Zwischenkreises des Batteriesystems startet. Im Anschluss daran, kann die Zuschaltung eines Relais erfolgen, sodass das Batteriesystem betriebsbereit ist.

In einem optionalen Schritt 495, der zeitlich nach der Bestimmung des ersten Stromwerts und des dritten Stromwerts, beispielsweise nach dem Schritt 445 durchgeführt wird, bestimmt das erste Mittel, das einen Verstärker mit einem dynamischen ersten Verstärkungsfaktor aufweist, einen zweiten Verstärkungsfaktor in Abhängigkeit des ersten Stromwerts und des dritten Stromwerts, wobei das erste Mittel den dynamischen ersten Verstärkungsfaktor mit dem zweiten Verstärkungsfaktor vergleicht und ein zweites Signal erzeugt wird, wenn der dynamische erste Verstärkungsfaktor und der zweite Verstärkungsfaktor übereinstimmen. Diese Prüfung ist für die Meßbereichsbestimmung des ersten Mittels erforderlich, da das erste Mittel in der Lage ist, unterschiedliche Spannungsbereiche zu erfassen. Um ASIL-C zu gewährleisten wird in diesem Ausführungsbeispiel das zweite Mittel benötigt, da die Spannungsversorgung des ersten Mittels für die Erfassung des ersten Spannungswerts und des dritten Spannungswert gleich ist, sodass eine unabhängige Referenz benötigt wird.

Wird kein erstes Signal erzeugt, d.h. der erste Stromwert, der zweite Stromwert und/oder der dritte Stromwert weisen eine große Differenz zueinander auf, so wird das Verfahren mindestens einmal erneut durchgeführt. Werden mehrere erfolglose Diagnosen durchgeführt, so wird der Diagnosemodus beendet und es wird ein Fehlersignal erzeugt, das den Anlauf des Batteriesystems verhindert.

In einem weiteren Ausführungsbeispiel werden der erste Stromwert, der zweite Stromwert und der dritte Stromwert mit denen im Speicher hinterlegten ersten Stromwerten, zweiten Stromwerten und dritten Stromwerten verglichen, sodass ein Alterungsdrift frühzeitig erkennbar ist.

In einem Ausführungsbeispiel wird eine Umgebungstemperatur erfasst. Dabei wird überprüft, ob die Umgebungstemperatur unterhalb eines für den Betrieb eines Batteriesystems zulässigen Schwellenwerts liegt. Ist dies der Fall, wird das erste Signal in Abhängigkeit des ersten Stromwerts, des zweiten Stromwerts und der Umgebungstemperatur erzeugt. In einem weiteren Ausführungsbeispiel wird zur Erzeugung des ersten Signals auch der dritte Stromwert herangezogen.

Durch das Verwenden einer Konstantstromquelle ist der Fehler der Vorrichtung bei sequentiellem Sampeln minimal. Da bei der Diagnose im Stromkreis ein Konstantstrom fließt, werden die Messwerte, d. h. die zu erfassenden Spannungswerte durch sequentielles Sampeln nicht beeinträchtigt. Ein weiterer Vorteil des Verwendens einer Konstantstromquelle ist, dass diese sowohl für das Überprüfen des ersten Widerstands, d. h. der Systemwiderstand des Batteriesystems, als auch für das Vorladen des Zwischenkreises verwendet werden kann. Somit wird die Konstantstromquelle gleich zweimal genutzt, während des Hochlaufs des Batteriesystems und während des Batteriebetriebs.

## Patentansprüche

1. Vorrichtung (200) zum Überprüfen einer Funktionsfähigkeit eines ersten Widerstands (202) eines Batteriesystems, wobei die Vorrichtung (200) eine Konstantstromquelle (205), einen Schalter (204), einen zweiten Widerstand (203), ein erstes Mittel (206) und ein zweites Mittel (207) aufweist, wobei das erste Mittel (206) dazu eingerichtet ist, einen ersten Spannungswert als Spannungsabfall über dem ersten Widerstand (202) zu erfassen, daraus einen ersten Stromwert zu bestimmen und den ersten Stromwert mit Hilfe einer Verbindung (208) an das zweite Mittel (207) zu übertragen, wobei das erste Mittel (206) einen Verstärker mit einem dynamischen ersten Verstärkungsfaktor aufweist, wobei das zweite Mittel (207) dazu eingerichtet ist einen zweiten Spannungswert als Spannungsabfall über dem zweiten Widerstand (203) zu erfassen und daraus einen zweiten Stromwert zu bestimmen, wobei das zweite Mittel (207) dazu eingerichtet ist, den ersten Stromwert und den zweiten Stromwert zu vergleichen, wobei das zweite Mittel (207) dazu eingerichtet ist, ein erstes Signal zu erzeugen, wenn der erste Stromwert und der zweite Stromwert im Wesentlichen gleich sind, wobei das erste Signal die Funktionsfähigkeit des ersten Widerstands repräsentiert, wobei die Vorrichtung (200) einen dritten Widerstand (209) aufweist, wobei das erste Mittel (206) dazu eingerichtet ist, einen dritten Spannungswert als Spannungsabfall über dem dritten Widerstand (209) zu erfassen, daraus einen dritten Stromwert zu bestimmen und den dritten Stromwert mit Hilfe der Verbindung (208) an das zweite Mittel (207) zu übertragen und das zweite Mittel (207) das erste Signal erzeugt, wenn der erste Stromwert, der zweite Stromwert und der dritte Stromwert im Wesentlichen gleich sind, wobei das erste Mittel (206) dazu eingerichtet ist, einen zweiten Verstärkungsfaktor in Abhängigkeit des ersten Stromwerts und des dritten Stromwerts zu bestimmen und mit dem dynamischen ersten Verstärkungsfaktor zu vergleichen und ein zweites Signal zu erzeugen, wenn der dynamische erste Verstärkungsfaktor und der zweite Verstärkungsfaktor im Wesentlichen übereinstimmen.

2. Vorrichtung (200) nach Anspruch 1, **dadurch gekennzeichnet, dass** das erste Mittel (206) ein Analog-Front-End und das zweite Mittel (207) eine Steuereinheit eines Batteriemanagementsystems des Batteriesystems ist.

3. Verfahren (400) zum Überprüfen einer Funktionsfähigkeit eines ersten Widerstands (202) eines Batteriesystems mit den Schritten:
• Starten (405) eines Diagnosemodus eines zweiten Mittels (207),
• Schließen (410) eines Schalters (204),
• Einschalten (420) einer Konstantstromquelle (205),
• Erfassen (430) eines ersten Spannungswerts als Spannungsabfall über einem ersten Widerstand (202) mit Hilfe eines ersten Mittels (206),
• Bestimmen (440) eines ersten Stromwerts in Abhängigkeit des ersten Spannungswerts und eines Nennwerts des ersten Widerstands (202),
• Erfassen (460) eines zweiten Spannungswerts als Spannungsabfall über einem zweiten Widerstand (203) mit Hilfe des zweiten Mittels,
• Bestimmen (470) eines zweiten Stromwerts in Abhängigkeit des zweiten Spannungswerts und eines Nennwerts des zweiten Widerstands (203),
• Übertragen des ersten Stromwerts an das zweite Mittel (207),
• Erzeugen (480) eines ersten Signals, das die Funktionsfähigkeit des ersten Widerstands (202) repräsentiert, wenn der erste Stromwert und der zweite Stromwert im Wesentlichen gleich sind,
• Erfassen eines dritten Spannungswerts mit Hilfe des ersten Mittels (206),
• Bestimmen (445) eines dritten Stromwerts in Abhängigkeit des dritten Spannungswerts und eines Nennwerts eines dritten Widerstands (209),
• Übertragen des dritten Stromwerts an das zweite Mittel (207),
• Erzeugen des ersten Signal, wenn der erste Stromwert, der zweite Stromwert und der dritte Stromwert im Wesentlichen gleich sind,
• Bestimmen (495) eines zweiten Verstärkungsfaktors in Abhängigkeit des ersten Stromwerts und des dritten Stromwerts durch das erste Mittel (206), das einen Verstärker mit einem dynamischen ersten Verstärkungsfaktor aufweist, wobei das erste Mittel (206) den dynamischen ersten Verstärkungsfaktor mit dem zweiten Verstärkungsfaktor vergleicht und ein zweites Signal erzeugt, wenn der dynamische erste Verstärkungsfaktor und der zweite Verstärkungsfaktor übereinstimmen,
• Beenden (490) des Diagnosemodus.

## Claims

1. Device (200) for checking a functionality of a first resistor (202) of a battery system, wherein the device (200) comprises a constant current source (205), a switch (204), a second resistor (203), a first means (206) and a second means (207), wherein the first means (206) is configured to detect a first voltage value as a voltage drop across the first resistor (202), to determine therefrom a first current value and to transfer the first current value to the second means (207) with the aid of a connection (208), wherein the first means (206) comprises an amplifier having a dynamic first gain factor, wherein the second means (207) is configured to detect a second voltage value as a voltage drop across the second resistor (203) and to determine therefrom a second current value, wherein the second means (207) is configured to compare the first current value and the second current value, wherein the second means (207) is configured to generate a first signal if the first current value and the second current value are substantially equal, wherein the first signal represents the functionality of the first resistor, wherein the device (200) comprises a third resistor (209), wherein the first means (206) is configured to detect a third voltage value as a voltage drop across the third resistor (209), to determine therefrom a third current value and to transfer the third current value to the second means (207) with the aid of the connection (208), and the second means (207) generates the first signal if the first current value, the second current value and the third current value are substantially equal, wherein the first means (206) is configured to determine a second gain factor as a function of the first current value and the third current value and to compare it with the dynamic first gain factor and to generate a second signal if the dynamic first gain factor and the second gain factor substantially match.

2. Device (200) according to Claim 1, **characterized in that** the first means (206) is an analogue front end and the second means (207) is a control unit of a battery management system of the battery system.

3. Method (400) for checking a functionality of a first resistor (202) of a battery system comprising the following steps:
• starting (405) a diagnostic mode of a second means (207),
• closing (410) a switch (204),
• switching on (420) a constant current source (205),
• detecting (430) a first voltage value as a voltage drop across a first resistor (202) with the aid of a first means (206),
• determining (440) a first current value as a function of the first voltage value and a nominal value of the first resistor (202),
• detecting (460) a second voltage value as a voltage drop across a second resistor (203) with the aid of the second means,
• determining (470) a second current value as a function of the second voltage value and a nominal value of the second resistor (203),
• transferring the first current value to the second means (207),
• generating (480) a first signal representing the functionality of the first resistor (202) if the first current value and the second current value are substantially equal,
• detecting a third voltage value with the aid of the first means (206),
• determining (445) a third current value as a function of the third voltage value and a nominal value of a third resistor (209),
• transferring the third current value to the second means (207),
• generating the first signal if the first current value, the second current value and the third current value are substantially equal,
• determining (495) a second gain factor as a function of the first current value and the third current value by way of the first means (206) comprising an amplifier having a dynamic first gain factor, wherein the first means (206) compares the dynamic first gain factor with the second gain factor and generates a second signal if the dynamic first gain factor and the second gain factor match,
• ending (490) the diagnostic mode.

## Revendications

1. Dispositif (200) destiné à vérifier une aptitude au fonctionnement d'une première résistance (202) d'un système de batterie, le dispositif (200) comprenant une source de courant constant (205), un commutateur (204), une deuxième résistance (203), un premier moyen (206) et un deuxième moyen (207), le premier moyen (206) étant conçu pour détecter une première valeur de tension en tant que chute de tension aux bornes de la première résistance (202), pour déterminer à partir de celle-ci une première valeur de courant et pour transmettre la première valeur de courant au deuxième moyen (207) à l'aide d'une connexion (208), le premier moyen (206) comprenant un amplificateur ayant un premier facteur de gain dynamique, le deuxième moyen (207) étant conçu pour détecter une deuxième valeur de tension en tant que chute de tension aux bornes de la deuxième résistance (203) et pour déterminer à partir de celle-ci une deuxième valeur de courant, le deuxième moyen (207) étant conçu pour comparer la première valeur de courant et la deuxième valeur de courant, le deuxième moyen (207) étant conçu pour générer un premier signal lorsque la première valeur de courant et la deuxième valeur de courant sont essentiellement égales, le premier signal représentant l'aptitude au fonctionnement de la première résistance, le dispositif (200) possédant une troisième résistance (209), le premier moyen (206) étant conçu pour détecter une troisième valeur de tension en tant que chute de tension aux bornes de la troisième résistance (209), pour déterminer à partir de celle-ci une troisième valeur de courant et pour transmettre la troisième valeur de courant au deuxième moyen (207) à l'aide de la liaison (208), et le deuxième moyen (207) générant le premier signal lorsque la première valeur de courant, la deuxième valeur de courant et la troisième valeur de courant sont essentiellement égales, le premier moyen (206) étant conçu pour déterminer un deuxième facteur de gain en fonction de la première valeur de courant et de la troisième valeur de courant et pour le comparer au premier facteur de gain dynamique et pour générer un deuxième signal lorsque le premier facteur de gain dynamique et le deuxième facteur de gain coïncident essentiellement.

2. Dispositif (200) selon la revendication 1, **caractérisé en ce que** le premier moyen (206) est un ensemble frontal analogique et le deuxième moyen (207) est une unité de commande d'un système de gestion de batterie du système de batterie.

3. Procédé (400) de vérification d'une aptitude au fonctionnement d'une première résistance (202) d'un système de batterie, comprenant les étapes :
• démarrage (405) d'un mode de diagnostic d'un deuxième moyen (207),
• fermeture (410) d'un commutateur (204),
• mise en circuit (420) d'une source de courant constant (205),
• détection (430) d'une première valeur de tension en tant que chute de tension aux bornes d'une première résistance (202) à l'aide d'un premier moyen (206),
• détermination (440) d'une première valeur de courant en fonction de la première valeur de tension et d'une valeur nominale de la première résistance (202),
• détection (460) d'une deuxième valeur de tension en tant que chute de tension aux bornes d'une deuxième résistance (203) à l'aide du deuxième moyen,
• détermination (470) d'une deuxième valeur de courant en fonction de la deuxième valeur de tension et d'une valeur nominale de la deuxième résistance (203),
• transmission de la première valeur de courant au deuxième moyen (207),
• génération (480) d'un premier signal qui représente l'aptitude au fonctionnement de la première résistance (202) lorsque la première valeur de courant et la deuxième valeur de courant sont sensiblement égales,
• détection d'une troisième valeur de tension à l'aide du premier moyen (206),
• détermination (445) d'une troisième valeur de courant en fonction de la troisième valeur de tension et d'une valeur nominale d'une troisième résistance (209),
• transmission de la troisième valeur de courant au deuxième moyen (207),
• génération du premier signal lorsque la première valeur de courant, la deuxième valeur de courant et la troisième valeur de courant sont essentiellement égales,
• détermination (495) d'un deuxième facteur de gain en fonction de la première valeur de courant et de la troisième valeur de courant par le premier moyen (206), qui possède un amplificateur ayant un premier facteur de gain dynamique, le premier moyen (206) comparant le premier facteur de gain dynamique au deuxième facteur de gain et générant un deuxième signal lorsque le premier facteur de gain dynamique et le deuxième facteur de gain coïncident,
• terminaison (490) du mode de diagnostic.
